(19) Europäisches Patentamt
European Patent Office
Office européen des brevets

(11) Publication number: 0 166 423 B1

(12) EUROPEAN PATENT SPECIFICATION

(45) Date of publication of patent specification: 27.02.91

(51) Int. Cl.5: H01L 27/08, H01L 27/02, H01L 23/52

(21) Application number: 85107845.1

(22) Date of filing: 25.06.85

(54) **Semiconductor integrated circuit having complementary field effect transistors.**

(30) Priority: 26.06.84 JP 131474/84

(43) Date of publication of application: 02.01.86 Bulletin 86/01

(45) Publication of the grant of the patent: 27.02.91 Bulletin 91/09

(84) Designated Contracting States: DE FR GB

(56) References cited:
EP-A- 0 013 482
WO-A-84/01454
US-A- 4 035 826

PATENT ABSTRACTS OF JAPAN, vol. 8, no. 167 (E-258)[1604], 2nd August 1984 & JP-A-59-63 754

IEEE JOURNAL OF SOLID-STATE CIRCUITS, vol. SC-19, no. 3, June 1984, pages 425-436, IEEE, New York, US; C.PIGUET et al.: "A metal-oriented layout structure for CMOS logic"

(73) Proprietor: NEC CORPORATION
7-1, Shiba 5-chome Minato-ku
Tokyo 108-01(JP)

(72) Inventor: Hashishita, Ryuichi
c/o NEC Corporation 7-1, Shiba 5-chome
Minato-ku Tokyo 108-01(JP)

(74) Representative: Glawe, Delfs, Moll & Partner
Patentanwälte
Postfach 26 01 62 Liebherrstrasse 20
D-8000 München 26(DE)

EP 0 166 423 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a semiconductor integrated circuit employing complementary MOS transistors.

Complementary MOS (hereinafter referred to as "CMOS") integrated circuits which employ both of N-channel field effect transistors and P-channel transistors have been widely utilized because they consume less electric power. In a CMOS integrated circuit, N-channel field effect transistors and P-channel field effect transistors are formed on different surface regions of a semiconductor substrate. For example, in the case where an N-type semiconductor substrate is employed, P-channel transistors are formed on a certain area of the substrate while a P-type well region is povided on another area of the substrate and N-channel transistors are formed on the well region. In order to arrange the transistors at high density, the above certain region and the well region are adjacently located and power supply wirings are arranged both outer sides of the adjacent certain region and the well regions. While, signal wirings for carrying logic signals are extended in the direction normal to that of the power supply wirings through the above two regions. According to this arrangement, the power supply wirings are arranged in parallel and the signal wirings are also arranged in parallel in each wiring group, and hence design in the wiring is easy. The signal wirings are extending beyond the power supply wirings from the transistor region and therefore the signal wirings inevitably overlap the power supply wirings. Therefore, in the case where the power supply wirings are made of low-resistive metal, the signal wirings are usually made of polycrystalline silicon in order to achieve the multi-layer wirings with ease. However, as is well-known, the resistance of the polycrystalline silicon is relatively large and hence the signal transmission time through the signal wirings is large, resulting in low speed operation. Moreover, the above overlap of the signal wirings on the power supply wirings and the formation of the power supply wirings outside the transistor region make it difficult to form the circuit with the high integration structure.

### Summary of the invention:

It is one object of the invention to provide a semiconductor integrated circuit which can be fabricated with high integration.

A semiconductor integrated circuit according to the preamble part of claim 1 is known from JP-A-59 63 754. In this device a N-type region and a P-type region surrounding the N-type region are formed and a plurality of signal wirings are extending through those regions in parallel with a power supply wiring.

A further semiconductor device is disclosed in US-A-4 035 826 in which a P-channel field effect transistor and a N-channel field effect transistor are formed in a first region surrounded by a N+-region and in a second region surrounded by a P+-region, respectively, and an input wiring and an output wiring are extending over the first and second regions.

It is therefore an object of the invention to provide a semiconductor integrated circuit which can be fabricated with high integration density and which is operable at a high speed.

This object is achieved by a semiconductor circuit having the features of claim 1. The dependent claims are related to further developments of the invention.

According to the invention both of the first and second power supply wiringspass over the first and second transistor forming regions in parallel in the direction perpendicular to that of the first and second transistor forming regions. Therefore, since both of the first and second transistor forming regions overlap with the first and second power supply wirings, any particular area on the substrate is not necessitated for the arrangement of the power supply wirings, and the transistors can be connected to either one or both of the power supply wirings with ease within the respective transistor forming regions. Thus, a high integration rate of the integrated circuit can be achieved. Furthermore, the internal wirings formed on the different level layers extend over both transistor forming regions to serve as the gates of the field effect transistors and extend in the same direction as that of the transistor forming regions. Therefore, the gates themselves of the transistor and the wirings connected between the gates and the single wirings can be formed by the internal wirings at the same time. Therefore, the field effect transistors can be formed over the transistor forming regions efficiently with high density structure.

### Brief description of the drawings:

| | |
|---|---|
| Fig. 1 | is a plan view showing a major part of a prior art integrated circuit; |
| Fig. 2 | is a plan view showing a major part of an integrated circuit according to the present invention; |
| Fig. 3 | is a schematic block diagram showing a logic circuit; |
| Fig. 4 | is a schematic circuit diagram of the logic circuit of Fig. 3; and |

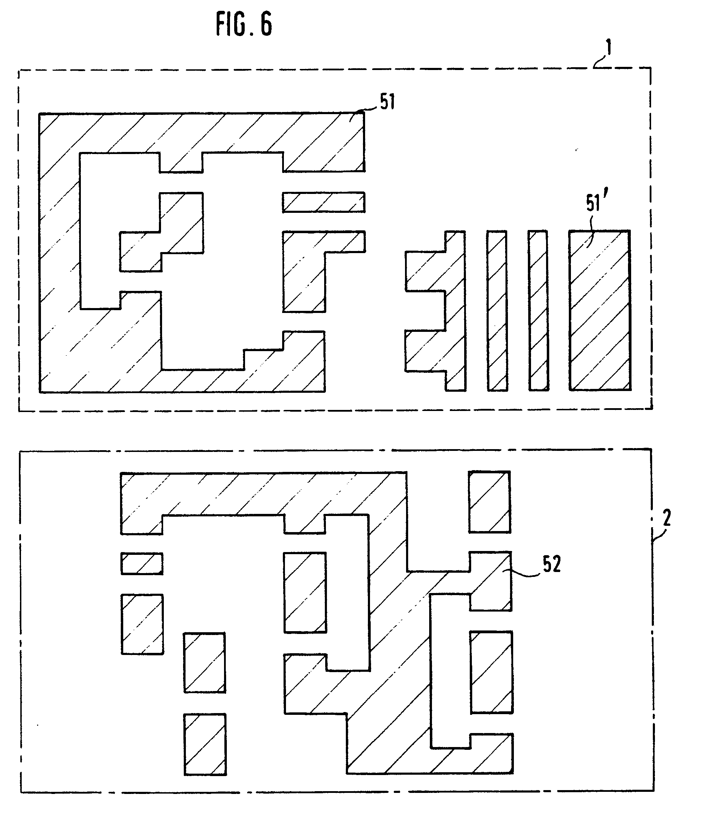

Figs. 5 and 6 are plan views showing one embodiment of the invention.

Detailed description of the invention:

Referring to fig. 1, a prior art CMOS integrated circuit is briefly explained.

As shown in fig. 1, two rectangular regions 1 and 2 are defined on a semiconductor substrate. The region 1 is, for example, of an N-type conductivity region and the region 2 is of a P-type conductivity region. In this case, P-channel field effect transistors are formed on the region 1 while N-channel field effect transistors are formed on the region 2. Along the upper side periphery 11 of the region 2, a power supply wiring $V_1$ is provided in a lateral direction and another power supply $V_2$ is provided in the lateral direction along the lower side periphery 12 of the region 2. Signal wirings S1 to S4 for carrying logic signals are provided in a vertical direction across the regions 1 and 2 as illustrated. In the drawing, an arrow with a reference "F" indicates the flow of logic processing in the circuit.

According to this arrangement, the power supply wirings $V_1$ and $V_2$ are formed on independent areas which are separate from the regions 1 and 2. Therefore, it has been difficult to fabricate the integrated circuit in a high-density structure. Furthermore, the signal wirings S1 to S4 are required to intersect with the power supply wiring $V_1$ and hence the signal wirings S1 to S4 must be formed by a different layer of conductive material. In general, the power supply wirings $V_1$ and $V_2$ are formed of a highly conductive metal e.g. aluminium and the signal wirings S1 to S4 are formed of a polycrystalline silicon. The resistance of the polycrystalline silicon is relatively and hence signal transmission time through the signal wirings inevitably large, resulting in low speed operation.

Referring to fig. 2, a basic structure of a CMOS integrated circuit according to the present invention is explained. In fig. 2, the portions corresponding to those in fig. 1 are denoted by the same references employed in fig. 1.

As is illustrated in fig. 2, according to the present invention, instead of arranging the power supply wirings $V_1$ and $V_2$ in the lateral direction along the peripheries 11 and 12 in fig. 1, the power supply wirings $V_1'$ and $V_2'$ are arranged in the vertical direction on both the regions 1 and 2. Also, the power supply wirings $V_1'$ and $V_2'$ are extending in parallel with the signal wirings S2 to S4.

According to this arrangement, since the power supply wirings $V_1'$ and $V_2'$ are formed on the transistor regions 1 and 2, the area solely required for the wirings $V_1'$ and $V_2'$ are not necessary. Moreover, the power supply wirings $V_1'$ and $V_2'$ and the signal wirings S1 to S4 are arranged in parallel and both of the wirings have no overlapping portion therebetween, and hence the signal wirings S1 to S4 can be formed of the same wiring layer as the power supply wirings $V_1'$ and $V_2'$. Namely, both of the signal wirings S1 to S4 and the power supply wirings $V_1'$ and $V_2'$ can be made by the same highly conductive material such as aluminium. Accordingly, the signal wirings S1 to S4 can be provided with low impedance as well as the power supply wiring.

Referring to figs. 3 to 6, a detailed embodiment of the present invention is explained.

Fig. 3 shows one example of a logic diagram of the circuit to be realized by the embodiment. As shown in fig. 3, the logic circuit to be fabricated in this embodiment includes a NAND gate $G_1$ receiving signals S1 and S2, an OR gate $G_2$ receiving the signals S1 and S2, a NAND gate $G_3$ receiving the outputs of the gates $G_1$ and $G_2$, and a NAND gate $G_4$ receiving signals S3 and S4 and the output of the gate $G_3$.

Fig. 4 shows a schematic circuit diagram of the logic circuit of fig. 3.

Referring to figs. 5 and 6, a detailed layout of the circuit shown in fig. 4 according to the invention is described.

On a semiconductor substrate 10, an N-type conductivity region 7 and a P-type conductivity region 2 are adjacently provided. P-channel transistors are formed on the region 7 while N-channel transistors are formed on the region 2.

A wiring 61 made of aluminium serves as the $V_5$ line and is extended in the vertical direction along and on the left side peripheries of the regions 1 and 2. A wiring 63 made of aluminium also serves as the $V_1'$ and is arranged in the vertical direction along and on the right side peripheries of the regions 1 and 2. An aluminium wiring 62 serves as the $V_2'$ line and is extending in the vertical direction through the center parts of the regions 1 and 2. Wirings 64 to 67 made of aluminium serve as the signal input lines S1 to S4, respectively and are extending in the vertical direction. The wiring 64 is connected to a polycrystalline silicon wiring 73 serving as gates of the P-channel transistors $Q_1$ and $Q_5$ through a contact 102 and connected to a polycrystalline silicon wiring 76 serving gates of the N-channel transistors $Q_3$ and $Q_9$ through a contact 121. The wiring 65 is connected to a polycrystalline silicon wiring 74 serving as the gates of the P-channel transistors $Q_2$ and $Q_6$ through a contact 104 and connected to a polycrystalline silicon wiring 79 serving as the gates of the N-channel transistors $Q_4$ and $Q_{10}$ through a contact 109. The wiring 66 is connected to an polycrystalline silicon wiring 80 serving a gate of the P-channel transistor $Q_{12}$ and a gate of the N-channel transistor $Q_{15}$

through a contact 114. The wiring 67 is connected to a polycrystalline silicon wiring 81 serving as a gate of the P-channel transistor $Q_{11}$ through a contact 120 and to a polycrystalline silicon wiring 82 serving as a gate of the N-channel transistor $Q_{16}$ An aluminium wiring 68 performs an internal connection connecting the commonly connected sources of $Q_1$ and $Q_2$ to gates of the transistors $Q_7$ and $Q_8$ via a contact 103, a polycrystalline silicon wiring 75, a contact 107 and a polycrystalline wiring 78. An aluminium wiring 72 connects the drains of the transistors $Q_{14}$, $Q_{15}$ and $Q_{16}$ to form an output terminal OUT.

The power wiring lines 61 and 63 are coupled to the P-type diffusion regions 51 and 51' via contacts 101 and 119, respectively. The power supply wiring 62 is connected to an N-type diffusion region 52 in the region 2 via contacts 113.

Fig. 6 shows a pattern of the diffusion regions 51, 51' and 52 for easier understanding.

As is apparent from fig. 5, the power supply wirings 61, 62 and 63 ($V_1$', $V_2$') are provided on the transistor forming regions 1 and 2 and hence any special area solely required for the wirings $V_1$', $V_2$' are not necessary. Moreover, the signal wirings 64 to 67 are formed in parallel with the power wirings 61 to 63 and of the same conductive layer (aluminium). Therefore, the signal wirings 64 to 67 can be provided with low impedance characteristics.

As has been described, according to the present invention, the semiconductor integrated circuit which can be fabricated at high-density and can operate at a high speed, is obtained.

## Claims

1. A semiconductor integrated circuit comprising
   a semiconductor substrate (10),
   a first transistor forming region (1) of a first conductivity type elongated at least in a first direction,
   a second transistor forming region (2) of a second conductivity type elongated at least in said first direction,
   a plurality of first field effect transistors (Q1, Q2, Q5-Q7, Q11-Q13) formed in said first transistor forming region (1),
   a plurality of second field effect transistors (Q3, Q4, Q8-Q10, Q14-Q16) formed in said second transistor forming region (2),
   first and second power supply wirings (V2', V1') extending on said semiconductor substrate (10),
   a plurality of signal wirings (S1-S4) passing over said first and second transistor forming regions (1,2) in the same direction as said first and second power supply wirings (V2' , V1'),
   first means for electrically connecting said first and second field effect transistors to said signal wirings (S1-S4), said first and second power supply wirings (V2', V1') and said signal wirings(S1-S4) being formed at a first wiring layer level without overlapping each other, **characterized** in that said first and second transistor forming regions being adjacent and parallel to each other,
   each of said first and second power supply wirings (V2', V1') pass over both of said first and second transistor forming regions (1, 2) in parallel and in a second direction perpendicular to said first direction, and
   that said first means includes a pluarality of internal wirings (73-82) formed on said first and second transistor forming regions (1, 2) and having portions extending in said first direction and serving as gates of said first and second transistors.

2. The semiconductor integrated circuit according to claim 1, **characterized** in that said power supply wirings (V2', V1') and said signal wirings (S1-S4) are formed of aluminium and said internal- wirings (73-82) are formed of polycrystalline silicon.

3. The semiconductor integrated circuit according to claim 1, **characterized** in that said first power supply wiring ((V2') is extending along substantially the center portions of said first and second transistor forming regions (1,2) and said second power supply wiring (V1') is arranged along one periphery of said first and second transistor forming regions, and that a third power supply wiring (V1') is further provided and extending in said second direction along the other periphery of said first and second transistor forming regions (1, 2).

## Revendications

1. Un circuit intégré semi-conducteur comprenant un
   substrat semi-conducteur (10),
   Une première région de formation des transistors (1) d'un premier type de conductivité allongée au moins dans une première direction,
   Une seconde région de formation des transistors (2) d'un second type de conductivité allongée au moins dans ladite première direction.

Une pluralité de premiers transistors à effet de champ (Q1, Q2, Q7, Q11, Q13) formés dans la dite première région de formation des transistors (1), une pluralité de seconds transistors à effet de champ (Q3, Q8, Q10, Q14, Q16) formés dans ladite seconde région de formation des transistors (2), un premier et un second conduoteurs d'alimentation (V2, V1') s'étendant sur ledit substrat semi-conducteur (10),
Une pluralité de fils de signalisation (S1-S4) passant sur lesdites première et seconde régions de formation des transistors (1,2) dans la même direction que lesdits premier et second conducteurs d'alimentation (V2', V1'), un premier moyen pour connecter électriquement lesdits premiers et seconds tansistors à effet de champ auxdits fils de signalisation (S1-S4), et lesdits fils de signalisation (S1-S4) étant formés à un premier niveau de couche de câblage sans se chevaucher, caractérisé en ce que lesdites première et seconde régions de formation des transistors sont adjacentes et parallèles l'une à l'autre chacun desdits premier et second conducteurs d'aluminium (V2', V1) passent au-dessus desdites première et seconde régions de formation de transistors (1,2) de manière parallèle et dans une seconde direction perpendiculaire à ladite première direction, et en ce que ledit premier moyen comprend une pluralité de conducteurs internes (73-82) formés sur lesdites première et seconde régions de formation des transistors (1,2) et ayant des parties s'étendant dans ladite première direction et servant de portes pour lesdits premiers et seconds transistors.

2. Le circuit intégré semi-conducteur conformément à la revendication 1, caractérisé en ce que lesdits conducteurs d'alimentation (V2' , V1') et lesdits fils de signalisation S1-S4) sont formés d'aluminium en ce que lesdits conducteurs internes (73 - 82) sont formés de silicium à polycristaux.

3. Le circuit intégré semi-conducteur conformément à la revendication 1, caractérisé en ce que ledit premier conducteur d'alimentation (V2') s'étend le long sensiblement des parties centrales desdites première et seconde régions de formation des transistors (1,2) et ledit second conducteur d'alimentation (V1') est disposé le long d'une périphérie desdites première et seconde régions de formation des transistors, et en ce que un troisième conducteur d'alimentation (V1') est en outre prévu et s'étendant dans ladite seconde direction le long de l'autre périphérie desdites première et seconde régions de formation des transistors (1,2)

## Ansprüche

1. Integrierte Halbleiterschaltung mit einem Halbleiterträger (10), einem einen ersten Transistor bildenden Bereich (1) eines ersten Leitungstyps, der zumindest in einer ersten Richtung ausgedehnt ist, einem einen zweiten Transistor bildenden Bereich (2) eines zweiten Leitungstyps, der zumindest in die erste Richtung ausgedehnt ist, einer Vielzahl von ersten Feldeffekttransistoren (Q1, Q2, Q5 bis Q7, Q11 bis Q13), die in dem den ersten Transistor bildenden Bereich (1) ausgebildet sind, einer Vielzahl von zweiten Feldeffekttransistoren (Q3, Q4, Q8 bis Q10, Q14 bis Q16), die in dem den zweiten Transistor bildenden Bereich (2) ausgebildet sind, einem ersten und zweiten Stromversorgungsleiter (V2', V1`), die sich auf dem Halbleiterträger (10) erstrecken, einer Vielzahl von Signalleitern (S1 bis S4), die über die den ersten und zweiten Transistor bildenden Bereiche (1, 2) in der gleichen Richtung wie der erste und zweite Stromversorgungsleiter (V2', V1') hinübergehen, einer ersten Einrichtung zum elektrischen Verbinden des ersten und zweiten Feldeffekttransistors mit den Signalleitern (S1 bis S4), wobei der erste und zweite Stromversorgungsleiter (V2', V1') und die Signalleiter (S1 bis S4) auf einem ersten Leiterschichtniveau ausgebildet sind, ohne sich gegenseitig zu überlappen, dadurch **gekennzeichnet,** daß die den ersten und zweiten Transistor bildenden Bereiche nebeneinander und parallel zueinander liegen, wobei der erste und der zweite Stromversorgungsleiter (V2', V1') jeweils über die beiden den ersten und zweiten Transistor bildenden Bereiche (1, 2) parallel und in einer zweiten Richtung rechtwinklig zu der ersten Richtung hinübergeht, und daß die erste Einrichtung eine Vielzahl von inneren Leitern (73 bis 82) umfaßt, die auf den die ersten und zweiten Transistoren bildenden Bereiche (1, 2) ausgebildet sind und Abschnitte aufweisen, die sich in die erste Richtung erstrecken und als Tore des ersten und des zweiten Transistors dienen.

2. Integrierte Halbleiterschaltung nach Anspruch 1, dadurch **gekennzeichnet**, daß die Stromversorgungsleiter (V2', V1') und die Signalleiter (S1 bis S4) aus Aluminium gebildet sind und die inneren Leiter (73 bis 82) aus polykristallinem Silizium gebildet sind.

3. Integrierte Halbleiterschaltung nach Anspruch 1, dadurch **gekennzeichnet**, daß der erste Stromversorgungsleiter (V2') sich im wesentlichen längs den Mittelabschnitten der den ersten und zweiten Transistor bildenden Bereiche (1, 2) erstreckt und der zweite Stromversorgungsleiter (V1') längs einer Peripherie der den ersten und zweiten Transistor bildenden Bereiche angeordnet ist, und daß ferner ein dritter Stromversorgungsleiter (V1') vorgesehen ist und sich in die zweite Richtung längs der anderen Peripherie der den ersten und zweiten Transistor bildenden Bereiche (1, 2) erstreckt.

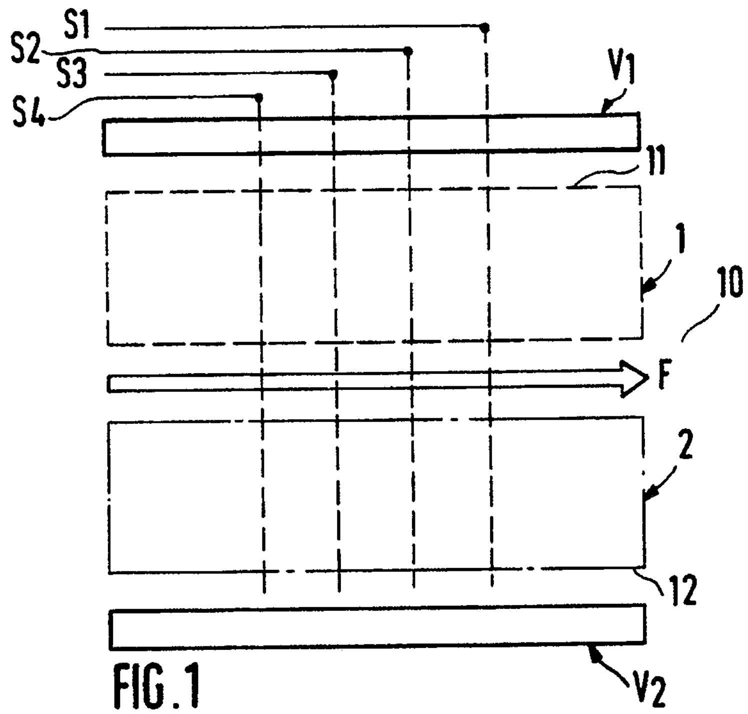


FIG.1

FIG.2

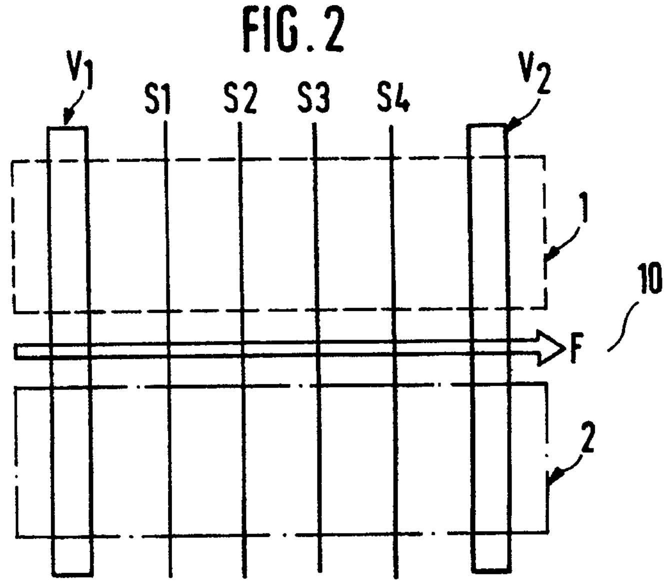

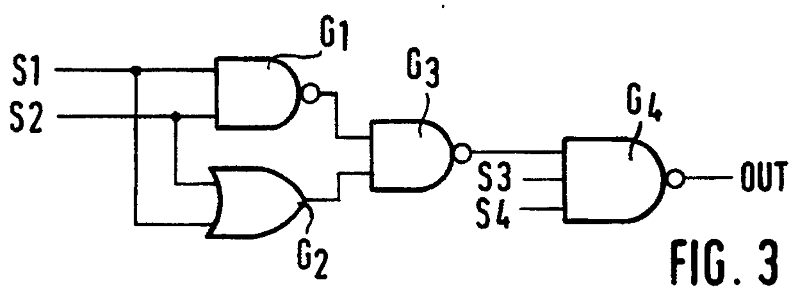
G1
G3
G4
S1
S2
S3
S4
OUT
G2

FIG. 3

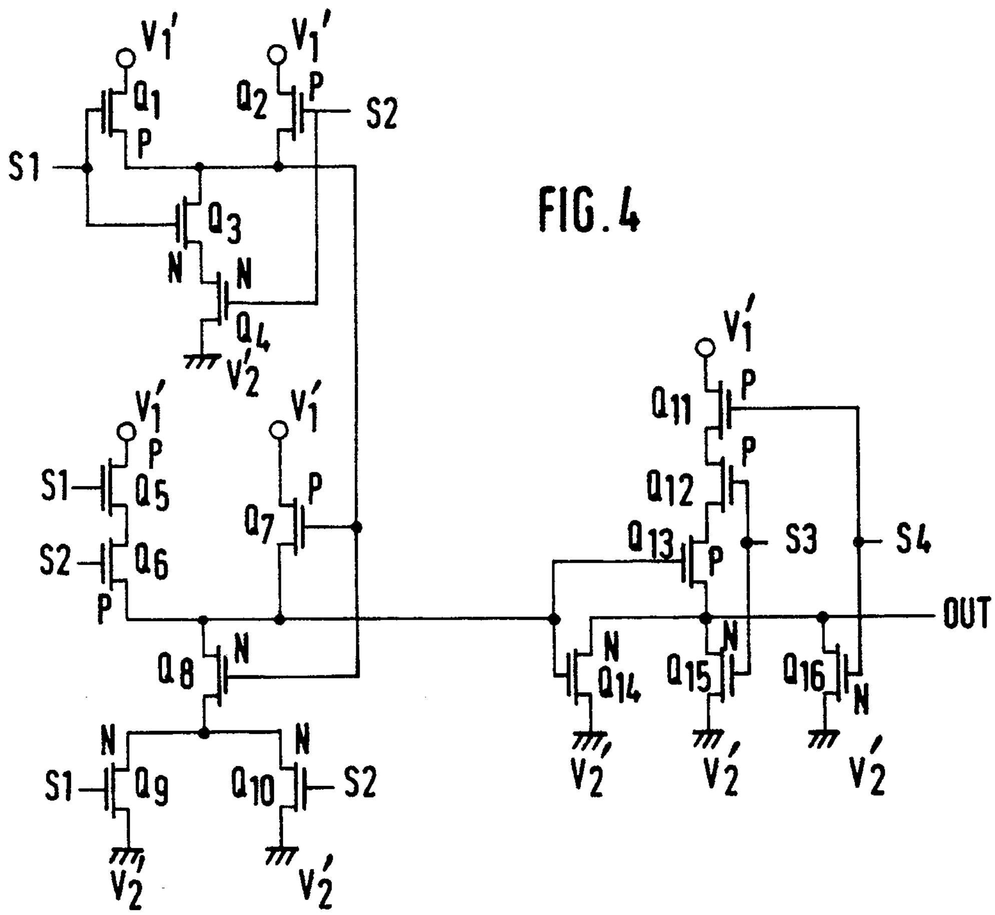
V1'
Q1
P
Q2
S2
S1
Q3
N
Q4
V2'
Q5
Q6
Q7
Q8
Q9
Q10
Q11
Q12
Q13
Q14
Q15
Q16
S3
S4
OUT

FIG. 4

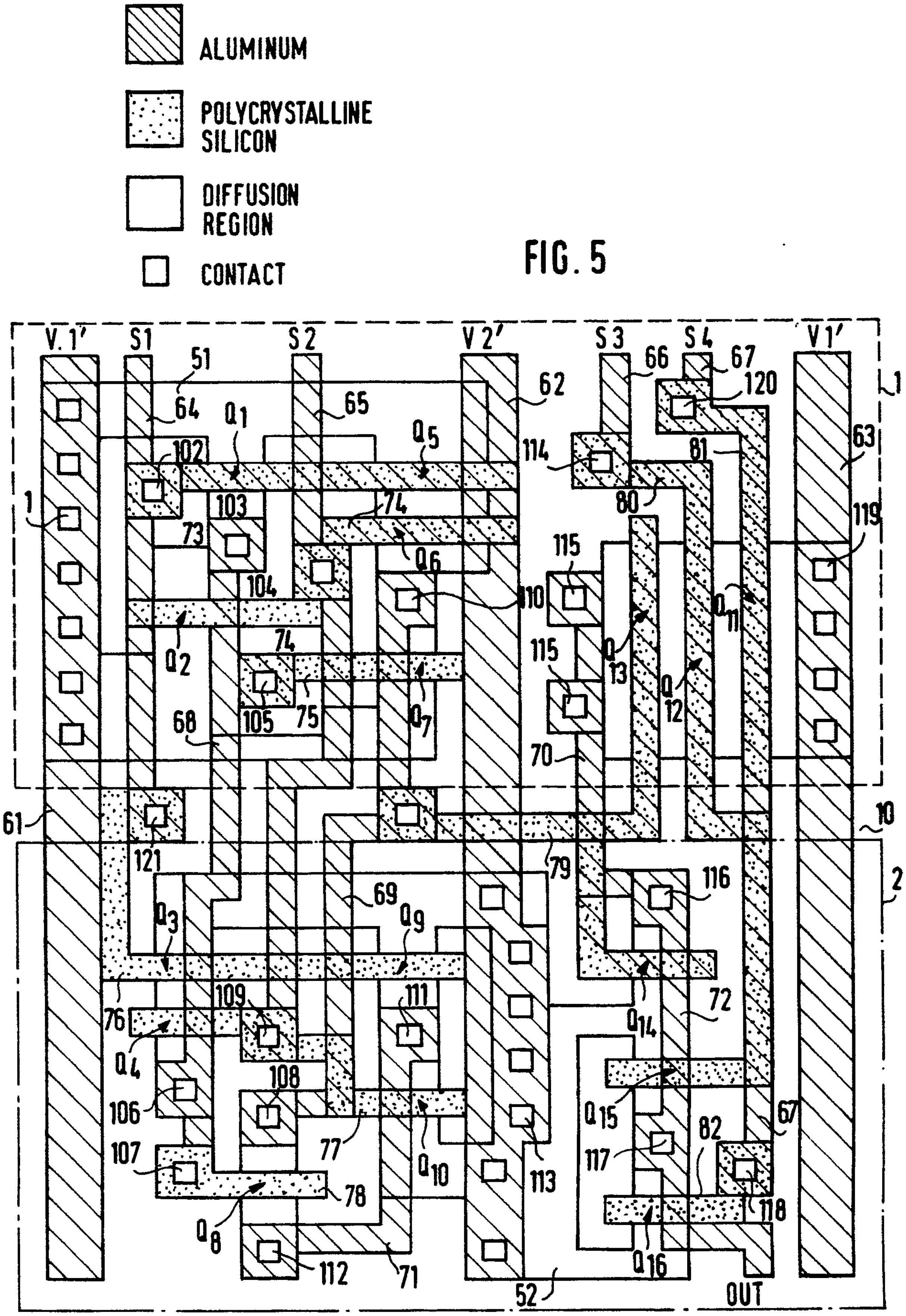
ALUMINUM
POLYCRYSTALLINE SILICON
DIFFUSION REGION
CONTACT
V.1'
S1
S2
V2'
S3
S4
V1'
51
62
63
64
65
66
67
120
Q1
Q5
102
114
81
80
103
73
74
Q6
104
110
115
Q2
Q11
Q13
Q12
Q7
105
75
68
70
61
121
10
79
2
Q3
69
Q9
116
72
76
109
111
Q14
Q4
108
Q15
106
107
77
Q10
113
117
82
78
Q8
118
112
71
52
Q16
OUT

FIG. 5

FIG. 6